# EUROPEAN PATENT SPECIFICATION

(11) **EP 0 498 248 B1**
(45) Date of publication and mention of the grant of the patent: **29.12.1997**
(21) Application number: 92101252.2
(22) Date of filing: 27.01.1992
(51) Int. Cl.: H03K 19/007

(54) **Fail-safe logic circuit**
Fehlersichere Logikschaltung
Circuit logique à sécurité intrinsèque

(30) Priority: 05.02.1991 JP 14172/91
(43) Date of publication of application: 12.08.1992
(73) Proprietor: HITACHI, LTD., Chiyoda-ku, Tokyo 100 (JP)
(72) Inventor: Nomi, Makoto, Kawasaki-shi (JP)
(74) Representative: Strehl Schübel-Hopf Groening & Partner

(56) References cited:
- US-A- 3 673 429
- US-A- 4 797 575
- PATENT ABSTRACTS OF JAPAN vol. 4, no. 162 (E-33)(644), 12 November 1980; & JP - A - 55110430 (MITSUBISHI DENKI K.K.) 25.08.1980
- PATENT ABSTRACTS OF JAPAN vol. 9, no. 61 (E-303)(1784), 19 March 1985; & JP - A - 59201523 (MITSUBISHI DENKI K.K.) 15.11.1984
- PATENT ABSTRACTS OF JAPAN vol. 13, no. 103 (E-725)(3451), 10 March 1989; & JP - A - 63276326 (HITACHI LTD) 14.11.1988

## Description

### BACKGROUND OF THE INVENTION

The present invention relates to a logic circuit suitable to attain a fail-safe logic in a system which requires reliability and safety.

In various recent control systems, relay logic circuits have been being replaced by electronic circuits such as microcomputers. However, since there is no assurance as to the status of the components of such electronic circuits when they become broken and since they do not have a fail-safe property of being turned off when they become broken, as relay logic circuits have, relay logic circuits are used rarely in systems which require fail-safe and safe control operations.

For example, in an automatic train controller (ATC) used in a railway, a control function is attained by electronic components which are configured into a triple majority system, and relays are used in the majority logic circuit.

On the other hand, trials have been made to attain a failsafe logic circuit by the electronic components. In one example, an oscillator is constructed by an analog circuit to represent logical "1" and "0" by the presence and absence of the oscillation, and the oscillation is stopped when there is a failure in the components.

The relay logic circuit naturally has a difficulty with respect to volume reduction, and its failure rate is not zero even if the electronic components are fail-safe. Rather, it has a higher failure rate than the electronic components due to bad contacts.

Further, since the oscillation type fail-safe logic circuit is difficult to be realised in integrated circuit technology such as by a digital circuit because it is constructed by the analog circuit, it is difficult to attain a reduction volume and cost. Further, it is limited in operation speed because of the nature of the circuit and hence it is used only in special applications.

JP-A-55-110430 discloses a fail-safe logic circuit which has the features included in the first part of claim 1. In this circuit, the D inputs of all flip-flops are connected to a power supply, and the output signal taken from each stage is applied to a reset input of the flip-flop in another stage. An additional final-stage flip-flop is used to provide the output signal of the overall circuit.

### SUMMARY OF THE INVENTION

It is an object of the present invention to realise a compact and high-speed fail-safe logic by a digital integrated circuit (digital IC).

This object is met by the circuit characterised in claim 1.

### BRIEF DESCRIPTION OF THE DRAWINGS

Fig. 1 shows a circuit diagram of a two-input AND logic circuit which is a basic circuit in an embodiment of the present invention,
Fig. 2 shows a time chart of an operation,
Fig. 3 shows a two-input AND logic circuit which represents two logical values by frequencies in an embodiment of the present invention,
Fig. 4 shows an operation timing chart of the logic circuit of Fig. 3,
Fig. 5 shows a differentiation circuit for edge detection in an embodiment of the present invention,
Fig. 6 shows an operation timing chart of Fig. 5,
Fig. 7 shows a majority logic circuit in an embodiment of the present invention, and
Fig. 8 shows an operation timing chart of Fig. 9.

### DESCRIPTION OF THE PREFERRED EMBODIMENTS

A principle of the present invention is first explained briefly.

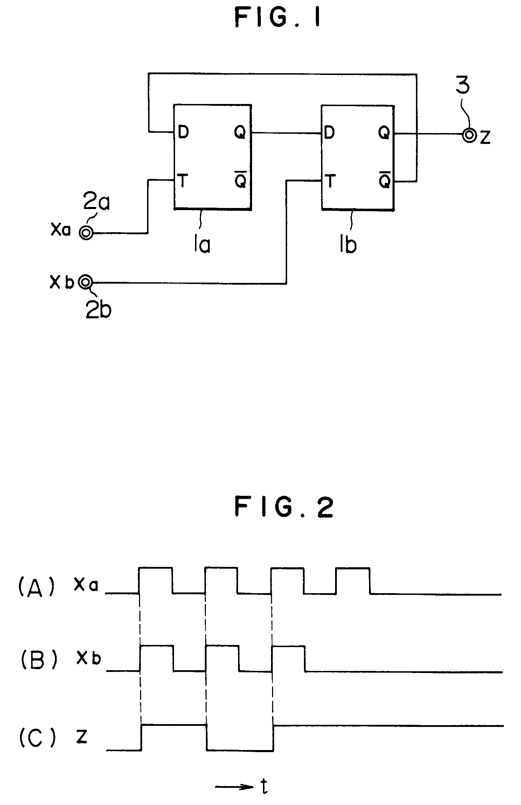

As shown in the timing chart of Fig. 2, signals Xa and Xb applied to a logic circuit are represented by an alternate (or pulse) signal which is turned on and off at a predetermined period so that the presence and absence of the alternation or the frequencies thereof represent logical values "1" and "0". Those signals are applied to a timing input terminal of each flip-flop. Thus, when both signal pulses Xa and Xb are present, the output of the flip-flop is shifted to the next stage. Since the output of the final stage flip-flop is inverted and connected to the first stage, an alternate signal appears at the output of the final stage flip-flop. On the other hand, when any one of the pulse signals Xa and Xb is not present, the shift does not occur and the output of the final stage flip-flop does not alternate. Thus, the circuit of Fig. 1 represents a two-input AND logic circuit.

When a flip-flop fails in this circuit, it does not normally operate as a flip-flop and the alternate output signal is not produced. Thus, a fail-safe digital IC logic circuit is provided.

Embodiments of the present invention will now be explained in detail with reference to the drawings.

Fig. 1 shows a circuit for illustrating a basic principle of the present invention. Signal input terminals 2a and 2b are connected to the timing input terminals of the flip-flops 1a and 1b, respectively. An output terminal 3 of the logic circuit is connected to the output of the final stage flip-flop.

As shown in the timing chart of Fig. 2, when the input signal pulses Xa and Xb are present, the flip-flops la and 1b of Fig. 1 shift their outputs to the next stages like a shift register. Since the output of the final stage flip-flop 1b is inverted and connected to the input of the first stage flip-flop la, the output which inverts between "1" and "0" appears at the output of the final stage flip-flop.

When one of the input signals, for example, the pulse Xb is absent, the output of the flip-flop 1b does not change because no pulse is applied to the timing input terminal. The same is applied when the input pulse Xa is absent. The alternate signal appears at the output only when both input pulses are present.

When the presence of the input pulses Xa and Xb represents the logical value "1" and the absence thereof represents the logical value "0" and the presence of the alternate output signal represents "1", the circuit of Fig. 1 attains a binary AND logic circuit.

The operation without failure in the logic circuit has been explained above. In the circuit of Fig. 1, the break of a connecting line always leads to the absence of the alternate signal, that is, the output is logical "0".

When one of the flip-flops la and 1b fails, that is, when the input D or the output Q is stuck to either "1" or "0", the alternation of the output disappears and the output is logical "0". In an exceptional case, if a complex failure occurs such that the signal to be applied to the timing input terminal T directly appears at the output Q of the flip-flop, the alternate signal appears at the output, but such a failure does not occur except when all internal gates are simultaneously broken.

Accordingly, the present circuit assumes logical "0" for almost all failures and the fail-safe operation is attained.

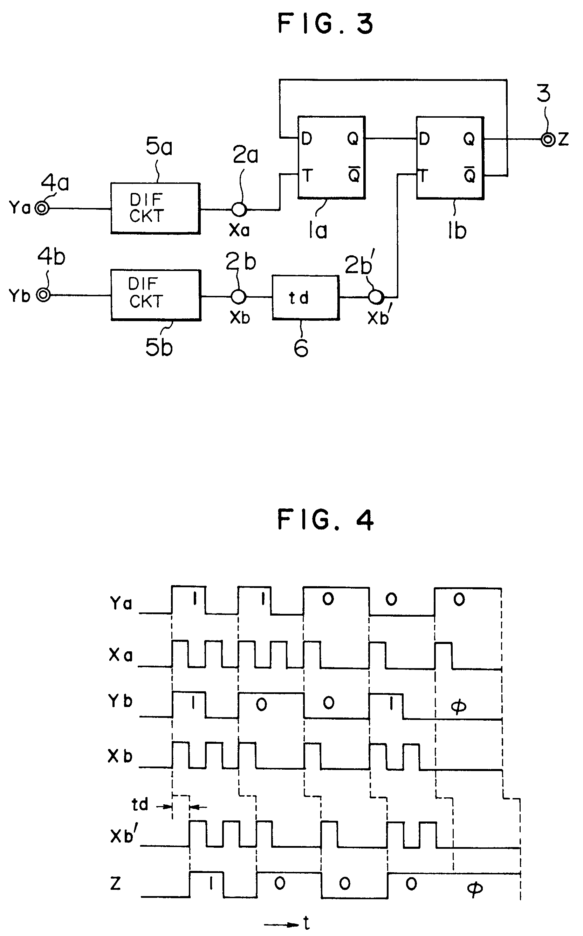

Fig. 3 shows an embodiment of a tri-state AND logic circuit in accordance with the basic principal circuit of Fig. 1. Numerals 1a and 1b denote flip-flops, numerals 5a and 5b denote input differentiation circuits and numeral 6 denotes a delay circuit.

In the circuit of Fig. 3, it is assumed that signals Ya and Yb shown in Fig. 4 represent logical "0" when they alternate once in a predetermined period, represent logical "1" when they alternate two times, and represent vacant (φ) when they do not alternate, where φ represents a failure or an error. When the signals Ya and Yb having such representations are applied to the input terminals 4a and 4b, the inputs Ya and Yb generate pulses at transition points of the signals by the differentiation circuits 5a and 5b to produce signal waveforms Xa and Xb. Signal Xa is applied to the timing input terminal of the flip-flop 1a as in Fig. 1. As to the signal Xb, it is delayed by a time t_{d} by the delay circuit 6 to produce a signal Xb', which is applied to the timing input terminal of the flip-flop 1b.

In this manner, as shown in the timing chart of Fig. 4, the flip-flops la and 1b form an AND logic circuit in which the output Z of the flip-flop 1b alternates two times per period to represent the logical "1" when both inputs Ya and Yb are logical "1", and the output Z alternates only once to represent the logical "0" when at least one of the inputs is logical "0". Further, if at least one of the inputs does not alternate to represent the vacancy (φ), the output also does not alternate to represent φ. On the other hand, if there is a failure in the circuit of Fig. 3, the output is φ. By using such a tri-state logic, the input error and the failure in the logic circuit can be discriminated from the normal operation. This increases the reliability to the operation result compared to the binary logic of Fig. 1 which is the fail-safe logic but can express only the logical values "1" and "0" and cannot discriminate the failure from "0". Further, since the input is differentiated, the input and the output are of the same form so that the output Z may be used as the input to the succeeding circuit.

While the two-input logic has been shown above, an n-input AND circuit may be configured by using n stages of flip-flops.

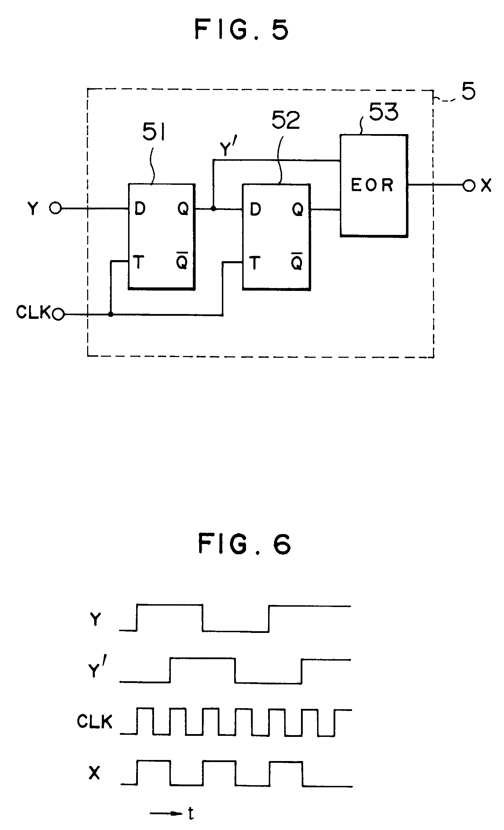

The differentiation circuit which is one component in Fig. 3 may be constructed by a flip-flop and an exclusive OR (EOR) gate as shown in Fig. 5, as is well known.

Fig. 5 shows a detail of the differentiation circuits 5a and 5b used in Fig. 3. The input Y is applied to flip-flops 51 and 52 forming a shift register, and the output thereof is applied to an exclusive OR (EOR) gate 53 to produce the differentiation output as shown in Fig. 6.

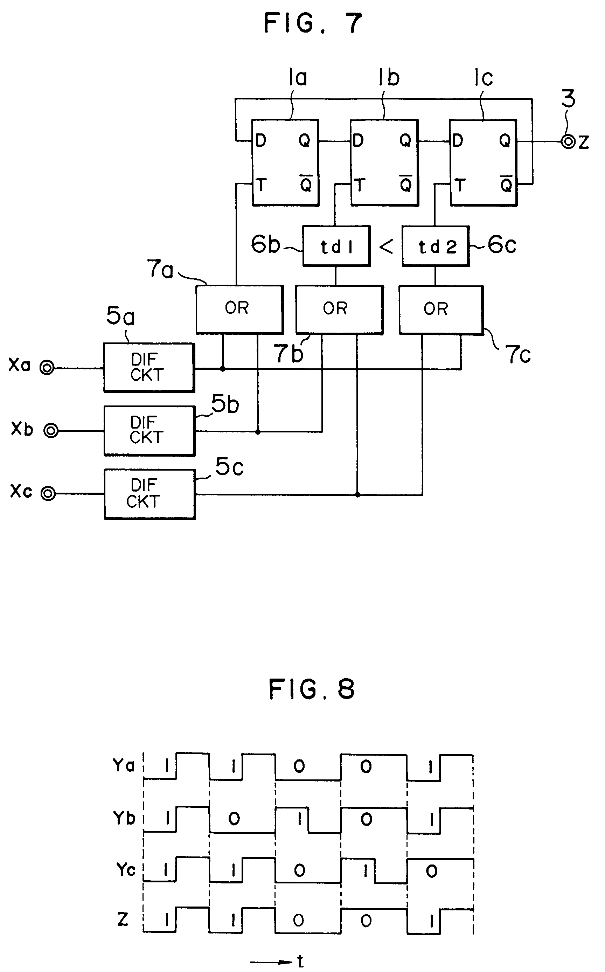

Fig. 7 shows an embodiment of a majority logic which is a combination of AND and OR. Numerals 1a, 1b and 1c denote flip-flops having inputs and outputs thereof connected in cascade and the output of the final stage flip-flop 1c is inverted and connected to the input of the flip-flop 1a. The three inputs Xa, Xb and Xc are applied to differentiation circuits 5a, 5b and 5c and the outputs thereof are ORed by two-input combination gates 7a, 7b and 7c. The outputs thereof are applied to the timing inputs of the flip-flops through delay circuits 6b and 6c having different delay times.

As shown in the timing chart of Fig. 8, the output Z is "1" when at least two of the three inputs are "1" and the output Z is "0" when at least two inputs are "0". In this manner, the majority logic is constructed. In the timing chart of Fig. 8, the shift of timing is omitted for simplification purpose.

In accordance with the present invention, the fail-safe logic circuit is constructed by using the conventional digital IC, and the fail-safe logic circuit which can be used in the system requiring the reliability and the safety can be readily constructed.

## Claims

1. A fail-safe logic circuit comprising at least two stages each including an edge-triggered D-type flip-flop (1a, 1b), wherein the non-inverted output signal of the flip-flop in each stage is applied to an input of the flip-flop in the respective subsequent stage, the inverted output signal of the last-stage flip-flop (1b) is applied to an input of the first-stage flip-flop (1a), and each flip-flop has its clock input (T) supplied with an independent timing signal (Xa, Xb), **characterised** in
that the input of each flip-flop (1a, 1b) to which the output signal of another flip-flop is applied is the D input, and
that the non-inverted output signal (Z) of the last-stage flip-flop (1b) is applied to the output (3) of the fail-safe circuit.

2. The circuit of claim 1, wherein the presence and absence of a pulse at the clock input (T) of each flip-flop (1a, 1b) represents a logic "1" and "0", respectively, and the presence and absence of an alternating signal at said circuit output (3) represents a logic "1" and "0", respectively, so that the fail-safe circuit functions as a logic AND gate.

3. The circuit of claim 1, wherein the input and output signals (Ya, Yb, Z) of the flip-flops (1a, 1b) have a predetermined period, with a signal alternating in half periods representing a logic "1" and a signal alternating in full periods representing a logic "0", wherein the transition point of an input pulse (Ya, Yb) is converted to a new pulse (Xa, Xb') applied to the clock input (T) of the respective flip-flop to correlate the logic values represented by the input pulses (Ya, Yb) and that represented by the output signal (Z).

4. The circuit of claim 3, wherein different delay times (T_{d}) are imparted to the pulses (Xa, Xb) applied to the clock inputs (T) of the flip-flops (1a, 1b).
